# EUROPEAN PATENT APPLICATION

(11) **EP 4 765 127 A1**
(43) Date of publication of application: **24.06.2026**
(21) Application number: 24221155.5
(22) Date of filing: 18.12.2024
(51) Int. Cl.: G11C 27/02

(54) **TOP-PLATE SAMPLING CIRCUITRY**

(71) Applicant: Imec VZW, 3001 Leuven (BE)
(72) Inventor: Craninckx, Jan, 3001 Leuven (BE); Martens, Ewout, 3001 Leuven (BE); Markulic, Nereo, 1040 Etterbeek (BE); Lagos Benites, Jorge Luis, 3001 Leuven (BE)
(74) Representative: Ipsilon Belgium

(57) **Abstract**

A top-plate sampling circuitry (10) for sampling a voltage input signal (11), the circuitry comprising: a sampling transistor (110) and a sampling capacitor (120); the sampling transistor being operable as a switch by a gate node (14) according to a tracking phase and a holding phase; a bootstrapper sub-circuitry (140) configured to bootstrap the voltage input signal with a fixed surplus voltage to a bootstrapped voltage (155), and to, during the tracking phase, provide the bootstrapped voltage to the gate node; and a gate switch (190) between the gate node and a fixed reference voltage (160), wherein the gate switch is configured to transition from open to closed during the switching, thereby opening the sampling transistor at a sampling time; wherein the circuitry is further configured to, during the switching from the tracking phase to the holding phase, provide a resistive coupling (180) between the bootstrapped voltage and the gate node.

## Description

### Technical field

The present invention generally relates to a top-plate sampling circuitry for sampling a voltage input signal.

### Background

In electronics, analogue-to-digital conversion, ADC, includes converting an analogue signal, i.e. a continuous-time, continuous-amplitude signal, to a digital signal, i.e. a discrete-time, quantised signal. Converting a signal from continuous time to discrete time, also referred to as sampling, is performed by a sampling circuitry. As such, an ADC circuitry usually comprises a sampling circuitry to perform this subtask.

Different types of sampling circuitries exist, e.g. voltage-based sampling circuitries and charge-based sampling circuitries. In a voltage-based sampling circuitry, a continuous-time voltage input signal is converted to a discrete-time voltage output signal.

Sampling needs to be performed in such a way as to introduce minimal nonlinearities to provide an accurate sampling, thereby minimising the introduction of sampling errors. Such sampling errors resulting from non-linear behaviour may, for example, result from an error as a result of undesired charge injection, a bandwidth limitation due to non-idealities, or an error in sampling moment. With accuracy is meant how close an amplitude of the voltage output signal is to the amplitude of the voltage input signal at an ideal sampling time. In addition, since the sampling circuitry is usually a first crucial stage, followed by multiple other circuitries which may introduce further errors, error margins for sampling are relatively small. This may be particularly critical in an ADC circuitry configured to operate at a relatively high resolution and/or at a relatively high speed.

### Summary

The present invention aims to alleviate at least some of the above mentioned obstacles.

The scope of protection sought for various embodiments of the invention is set out by the independent claims.

The embodiments and features described in this specification that do not fall within the scope of the independent claims, if any, are to be interpreted as examples useful for understanding various embodiments of the invention.

According to a first aspect, a top-plate sampling circuitry for sampling a voltage input signal is provided. The circuitry comprises a sampling transistor and a sampling capacitor; a bootstrapper sub-circuitry; and a gate switch between the gate node and a fixed reference voltage. The sampling transistor connects the voltage input signal to a top plate of the sampling capacitor. The sampling transistor is operable as a switch by a gate node according to a tracking phase and a holding phase; wherein, during the tracking phase, the sampling transistor is closed and conducts the voltage input signal onto the top plate; and wherein, upon switching from the tracking phase to the holding phase, the sampling transistor is opened such that the voltage input signal is sampled on the top plate as a voltage output signal, and maintained during the holding phase. The bootstrapper sub-circuitry is configured to bootstrap the voltage input signal with a fixed surplus voltage to a bootstrapped voltage, and the bootstrapper sub-circuitry is configured to, during the tracking phase, provide the bootstrapped voltage to the gate node, thereby keeping the sampling transistor closed by the fixed surplus voltage. The gate switch is configured to transition from open to closed during the switching from the tracking phase to the holding phase, thereby opening the sampling transistor at a sampling time. The top-plate sampling circuitry is further configured to, during the switching from the tracking phase to the holding phase, provide a resistive coupling between the bootstrapped voltage and the gate node, thereby allowing a difference between a gate voltage at the gate node and a source voltage at a source node to drop below a threshold voltage of the sampling transistor so as to open the sampling transistor.

In the present disclosure, bootstrapping is defined as following the progression, for example a slope or gradient, of an input signal, yet with an amplitude difference. The bootstrapper sub-circuitry is thus configured to, at least during the tracking phase, provide a bootstrapped voltage that progresses according to a slope, i.e. gradient, of a voltage input signal with an amplitude difference equal to a fixed surplus voltage. The bootstrapped voltage thereby follows the voltage input signal. A variation, i.e. slope, of the bootstrapped voltage may be delayed in time with respect to a variation or slope of the voltage input signal. The fixed surplus voltage has a constant value, which may be positive or negative.

A difference between a gate voltage at a gate node and a source voltage at a source node determines a state of the sampling transistor, i.e. open or closed, i.e. non-conducting or conducting current respectively. The sampling transistor may also be referred to as a sampling switch, since the sampling transistor is configured as a switch.

By providing the bootstrapped voltage to the gate node, a voltage difference is provided between the gate node and a source node of the sampling transistor that is at least equal to a threshold voltage of the sampling transistor. The threshold voltage is a fixed parameter of the sampling transistor that determines a value of the gate-source voltage as of which the sampling transistor starts conducting current. The gate-source voltage is a difference between the gate voltage and the source voltage. During conducting of the sampling transistor, a difference between the gate-source voltage and the threshold voltage may be referred to as an overdrive voltage of the sampling transistor. The overdrive voltage may determine how much the sampling transistor is conducting. As the gate-source voltage is further increased above the threshold voltage, the sampling transistor conducts more current, i.e. a resistance of the sampling transistor reduces. In other words, when the difference between the gate voltage and the source voltage is equal to or larger than the threshold voltage, the sampling transistor is conducting, i.e. provides a conductive channel between the source and the drain of the sampling transistor. As a result, during the tracking phase, the sampling transistor conducts current and the voltage output signal tracks, i.e. copies, the voltage input signal. During the tracking phase, a gate-source voltage is to be significantly larger than the threshold voltage, to allow the sampling transistor to conduct current with a low resistance. The voltage difference between gate node and source node is equal to the fixed surplus voltage. In other words, an absolute value of the fixed surplus voltage exceeds an absolute value of the threshold voltage of the sampling transistor. For example, if the sampling transistor is an N-channel metal-oxide semiconductor, NMOS, transistor, i.e. having a positive threshold voltage, the fixed surplus voltage is larger than or equal to the threshold voltage of the sampling transistor. For example, if the sampling transistor is a P-channel metal-oxide semiconductor, PMOS, transistor, i.e. having a negative threshold voltage, the fixed surplus voltage is smaller than or equal to the threshold voltage of the sampling transistor.

The top-plate sampling circuitry may be configured to, during operation, alternate between the tracking phase and the holding phase. This may be implemented by providing a clock signal at the gate switch, wherein one clock period of the clock signal has a duration equal to the duration of the tracking phase added to the duration of the holding phase. In other words, one clock cycle corresponds to one sampling cycle of tracking and holding. By applying the clock signal, the gate switch may be configured to transition from open to closed during a clock edge of the clock signal. As such, the clock edge may, for example, correspond to the sampling time.

A resistive coupling between the bootstrapped voltage and the gate node is provided during the sampling time. At the sampling time, the gate switch is being closed and as a result the gate voltage is pulled towards the fixed reference voltage. This is only possible thanks to the resistive coupling occurring at the moment wherein the gate voltage is pulled towards the fixed reference voltage, which provides an uncoupling of the bootstrapped voltage from the gate node. The resistive coupling introduces a voltage drop between the bootstrapped voltage and the gate node. Without the resistive coupling, the bootstrapped voltage would also be pulled towards the fixed reference voltage at the sampling time, and the bootstrapper sub-circuitry and the fixed reference voltage would work against each other, preventing the gate-source voltage from dropping below the threshold voltage of the sampling transistor. In other words, the resistive coupling provides, during the switching, a disengagement between the bootstrapper sub-circuitry, which is configured to be active during the tracking phase, and the gate switch, which is configured to be active during the holding phase. Thereby, the bootstrapper sub-circuitry and the gate switch can operate alternatingly without interfering with each other during the changeover between the tracking phase and the holding phase.

The top-plate sampling circuitry according to the first aspect demonstrates a highly linear behaviour due to the following reasons.

As a result of the fixed surplus voltage over the sampling transistor during tracking, the inherent resistance of the sampling transistor, e.g. the small signal output impedance, remains independent of the amplitude of the voltage input signal. This causes the frequency behaviour of the sampling transistor to remain signal-independent as well. As a result, the sampling transistor does not introduce any signal-dependent components to the transfer function of the top-plate sampling circuitry. Consequently, the sampling transistor prevents a signal-dependency of the bandwidth of the top-plate sampling circuitry.

Also as a result of the fixed surplus voltage over the sampling transistor, there is no non-linear signal-dependent charge injection into the channel of the sampling transistor in function of the gate-source voltage. Charge injection resulting from other capacitive effects in the sampling transistor may occur but depend on the input voltage in a linear way. For example, the clock signal may cause a charge injection via a gate-drain capacitance of the sampling transistor. This undesired effect may be referred to as clock feedthrough. It is noted that linear signal-dependent errors have a much smaller impact on the performance of the sampling circuitry than non-linear signal-dependent effects. In addition, they can also be compensated more easily.

Further, due to the configuration of the top-plate sampling circuitry, the sampling time is also independent of the amplitude of the voltage input signal. An effective, i.e. actual or real, sampling time is determined by the time it takes for the gate switch and subsequently the sampling transistor to close.

The amount of time it takes for the gate switch to close does not vary in function of the voltage input signal. The reason being that the gate switch is connected to the fixed reference voltage, which can be assumed to remain constant over time. The fixed time at which the gate switch closes results in a fixed time for the gate voltage to start dropping towards a value of the fixed reference voltage. Upon closing of the gate switch, the gate voltage starts dropping, while the voltage input signal at the source node may keep varying.

Right before closing of the gate switch, the gate-source voltage of the sampling transistor is equal to the fixed surplus voltage due to the bootstrapping. Therefore, in order for the sampling transistor to open, the gate-source voltage needs to drop starting from an amount equal to the fixed surplus voltage. Since this amount is the same during every clock cycle, achieving the voltage drop to open the sampling transistor may take a time that is also the same every clock cycle. The resistive coupling ensures that this results in a sampling time independent of the voltage input signal. Without the resistive coupling, the fixed rate at which the gate voltage drops would, along with the voltage input signal that may be fluctuating at the source, result in a signal-dependent time needed for the gate-source voltage to drop below the threshold voltage. As a result, the sampling time would fluctuate as a function of the voltage input signal at the source. The resistive coupling allows the gate voltage to keep following bootstrapped variations in the input voltage as the sampling transistor is opening, while the gate voltage is being pulled to the fixed reference voltage. Thereby, the gate-source voltage is allowed to drop at a rate independently of any further fluctuations of the voltage input signal. Thus, thanks to the resistive coupling, it takes an amount of time independent of the input signal for the gate-source voltage to drop to and below the threshold voltage. Thereby, the sampling transistor is opened at a signal-independent moment in time.

It is noted that the configuration to obtain these effects is made possible by the resistive coupling during the switching. The resistive coupling allows separation of tracking and holding without a need for additional switches, which may cause non-linear signal-dependent effects and/or may negatively influence the bandwidth, e.g. by stacking impedances in series.

Due to its linear characteristics, the top-plate sampling circuitry is able to operate at a low voltage, i.e. has a low power consumption, to obtain a certain error margin.

According to further example embodiments, the top-plate sampling circuitry is further configured to further provide the resistive coupling during the tracking phase.

By also providing the resistive coupling during other moments than the sampling moment, it may be easier to implement the resistive coupling, e.g. by a component requiring limited or no controlling. For example, if the resistive coupling comprises a resistor, no controlling is required.

According to further example embodiments, the top-plate sampling circuitry is further configured to further provide the resistive coupling during the holding phase.

By providing the resistive coupling while the gate switch is closed, it is avoided that the bootstrapped voltage is pulled to the fixed reference voltage. If the bootstrapped voltage were to be shorted to the fixed reference voltage, this would be in conflict with the operation of the bootstrapping sub-circuitry. This would lead to the malfunction of the top-plate sampling circuitry.

If the resistive coupling is provided as a constant resistive coupling, i.e. the same during the tracking phase and the holding phase, the resistive coupling may preferably be a moderate resistive coupling. If the resistive coupling is too large, the bootstrapper sub-circuitry is not able to drive the gate voltage during the tracking phase. If the resistive coupling is too small, the bootstrapped voltage may be shorted during the holding phase. A moderate resistive coupling may, for example, be between a small resistive coupling, e.g. in the order of 10 Ohm, Ω, and a large resistive coupling, e.g. in the order of 1 giga Ohm, GΩ. The resistive coupling may, for example, be comprised between 50 Ω, and 5 kΩ, more preferably between 0.1 kilo Ohm, kΩ, and 1 kΩ, e.g. 0.5 kΩ.

According to further example embodiments, the top-plate sampling circuitry is further configured to, during an initial portion of the tracking phase, shortcut the bootstrapped voltage to the gate node so as to accelerate settling of the gate voltage to the bootstrapped voltage following the voltage input signal.

At the start of the tracking phase, a voltage difference needs to be achieved between the gate node and the source node of the sampling transistor. This voltage difference needs to be at least equal to the threshold voltage, to cause the sampling transistor to conduct current so as to track the voltage input signal to the output. Preferably, the voltage difference needs to be significantly higher than the threshold voltage so as to conduct current with a low impedance. For example, if the sampling transistor is a metal-oxide semiconductor field-effect transistor, MOSFET, transistor, the voltage difference may be large enough to bias the sampling transistor in a linear region. This is done by the bootstrapper sub-circuitry, which provides this voltage difference as the fixed surplus voltage. Settling of the gate voltage takes some time due to non-ideal transitory effects, e.g. non-zero rise times such as, for example, resulting from a non-zero settling time constant through the resistive coupling. The settling may comprise rising or dropping of the gate voltage in accordance with the bootstrapped voltage at the beginning of the tracking phase. This may, for example, depend on the implemented technology. For example, if the sampling transistor is an NMOS transistor or a PMOS transistor, the settling respectively comprises rising or dropping. This is due to the threshold voltage of an NMOS transistor being positive, while the threshold voltage of a PMOS transistor is negative.

The shortcutting comprises connecting the output of the bootstrapper sub-circuitry to the gate node via a path having a lower resistance, i.e. a lower-Ohmic path. Thus, if the resistive coupling is provided during the tracking phase, the shortcutting comprises bypassing the resistive coupling. By directly providing the bootstrapped voltage on the gate node, the gate voltage equals the bootstrapped voltage. Thereby, speeding up is obtained of the controlling of the sampling transistor by the bootstrapped voltage. In other words, faster starting up of the tracking phase is achieved.

According to further example embodiments, the top-plate sampling circuitry further comprises a start-up switch for performing the shortcutting by shortcutting the resistive coupling, and the start-up switch is configured to be closed during the initial portion and open at least during the switching from the tracking phase to the holding phase.

By performing the shortcutting using a single switch, an efficient implementation is provided.

According to further example embodiments, the start-up switch is provided in parallel with the resistive coupling.

According to further example embodiments, the top-plate sampling circuitry is further configured to, during an end portion of the holding phase, interrupt the bootstrapping so as to limit current otherwise flowing from the bootstrapper sub-circuitry through the resistive coupling to the fixed reference voltage.

After entering the holding phase, the bootstrapper sub-circuitry is not actively involved to perform the sampling. By limiting the current, power can be saved.

According to further example embodiments, the top-plate sampling circuitry further comprises a power-saving switch for the interrupting of the bootstrapping by disconnecting the supplied bootstrapped voltage from the gate node; and the power-saving switch is configured to be open during the end portion of the tracking phase and closed at least during the switching from the tracking phase to the holding phase.

By interrupting the bootstrapping of the gate node using a single switch, an efficient implementation is provided.

According to further example embodiments, the interrupting comprises disabling the bootstrapper sub-circuitry. As such, current consumed by the bootstrapper sub-circuitry itself may also be limited.

According to further example embodiments, the top-plate sampling circuitry further comprises a second transistor configured as the power-saving switch, wherein the second transistor is further configured to provide the resistive coupling between the bootstrapped voltage and the gate node when the second transistor is closed.

By providing the resistive coupling using a transistor, the resistive coupling can be configured over time. In other words, the resistive coupling can be provided at selected moments in time. For example, this allows providing the resistive coupling only during the switching from the tracking phase to the holding phase. It also allows adapting a resistance value. In addition, by providing the second transistor, a single electronic component, in other words, only one electronic component, is provided to achieve both the functionality of the power-saving switch as well as the resistive coupling. As such, an efficient implementation is provided in terms of area usage.

According to further example embodiments, the top-plate sampling circuitry further comprises an inverter configured to provide a second gate voltage for controlling a second gate node of the second transistor. The inverter may be powered by a voltage difference between the voltage input signal and the bootstrapped voltage. The inverter may further be configured to provide the second gate voltage such that the second transistor is open during the end portion of the tracking phase and closed at least during the switching from the tracking phase to the holding phase.

According to further example embodiments, the power-saving switch is provided in series with the resistive coupling.

By providing the power-saving switch in series, the disconnecting is performed immediately upon opening the power-saving switch.

According to further example embodiments, the start-up switch is configured in parallel over the resistive coupling and the power-saving switch.

By providing the start-up switch in parallel, the shortcutting is performed immediately upon closing the start-up switch.

According to further example embodiments, the top-plate sampling circuitry further comprises a resistor between the bootstrapped voltage and the gate node to provide the resistive coupling as a constant resistive coupling.

By providing the resistor, the resistive coupling is provided at all times, i.e. during both the tracking phase and the holding phase. In addition, the resistive coupling is linear. Providing a resistor is an efficient way of implementing the resistive coupling that results in a signal-independent behaviour.

According to further example embodiments, the top-plate sampling circuitry further comprises a voltage buffer configured to buffer the voltage input signal; the sampling transistor connects the voltage input signal to the top plate of the sampling capacitor via the voltage buffer; and the bootstrapper sub-circuitry is configured to take the voltage input signal of the voltage buffer as input.

The voltage buffer is configured to linearise the voltage input signal to generate a buffered voltage input signal having a lower impedance than the voltage input signal. In addition, the voltage buffer provides a lower capacitance to be driven by a driver of the sampling circuitry. Such a driver may, for example, drive the voltage input signal. By providing the voltage buffer, a more optimal sampling can be performed.

According to further example embodiments, the bootstrapper sub-circuitry comprises a level-shifting capacitor between the input voltage signal and the bootstrapped voltage for providing the fixed surplus voltage.

By providing the level-shifting capacitor, the fixed surplus voltage can be generated using a simple, passive electronic component.

According to further example embodiments, the level-shifting capacitor is connected to the voltage input signal at one end and to an input of an active bootstrapper buffer on the other end, thereby providing the fixed surplus voltage across the level-shifting capacitor; and an output of the active bootstrapper buffer provides the bootstrapped voltage.

The fixed surplus voltage is preferably provided across the plates of the level-shifting capacitor.

According to further example embodiments, the level-shifting capacitor is configured as a battery capacitor and is further configured to be periodically recharged during the holding phase.

The battery capacitor is configured to be connected to the sampling circuitry during the tracking phase. During the tracking phase, the battery capacitor may be at least partially discharged. The battery capacitor is configured to be disconnected from the sampling circuitry during the holding phase. During the holding phase, the battery capacitor can be connected to an external voltage supply for the recharging. This can be repeated during each holding phase to perform the periodic recharging.

According to further example embodiments, the top-plate sampling circuitry further comprises a capacitance between the gate node and an input node of the sampling transistor to hold the fixed surplus voltage during the tracking phase.

The capacitance may, for example, be provided by a physical capacitor, or may, for example, be a parasitic capacitance.

The capacitance provides a second path from the input node to the gate node. A first path from the input node to the gate node comprises a path via the bootstrapper. The first path provides a direct path for a low-frequency portion of the voltage input signal. The second path provides a direct path for a high-frequency portion of the voltage input signal, thereby allowing the gate node to better follow the gradient of the input voltage. In other words, a more accurate tracking is achieved. Furthermore, the capacitance aids in holding the fixed surplus voltage during the tracking phase. As a result, the fixed surplus voltage may remain more constant during the tracking phase. This may further add to the signal-independence of the resistance of the sampling transistor and therefore to an increased linearity of the sampling circuitry.

According to further example embodiments, the fixed surplus voltage is held on the gate node during the tracking phase by a parasitic capacitive coupling between the gate node and an input node of the sampling transistor.

According to further example embodiments, the fixed reference node is a ground node.

According to a second aspect, an analogue-to-digital converter circuitry is provided comprising the top-plate sampling circuitry according to the first aspect.

### Brief Description of the Drawings

Fig. 1 illustrates a top-plate sampling circuitry according to example embodiments;
Fig. 2 illustrates voltage signals in a top-plate sampling circuitry according to example embodiments;
Fig. 3 illustrates a top-plate sampling circuitry according to example embodiments;
Fig. 4 illustrates voltage signals in a top-plate sampling circuitry according to example embodiments;
Fig. 5 illustrates a top-plate sampling circuitry according to example embodiments;
Fig. 6 illustrates voltage signals in a top-plate sampling circuitry according to example embodiments;
Fig. 7 illustrates a top-plate sampling circuitry according to example embodiments;
Fig. 8 illustrates a top-plate sampling circuitry according to example embodiments;
Fig. 9 illustrates voltage signals in a top-plate sampling circuitry according to example embodiments;
Fig. 10 illustrates a top-plate sampling circuitry according to example embodiments;
Fig. 11 illustrates a top-plate sampling circuitry according to example embodiments; and
Fig. 12 illustrates signal-dependent delays in a top-plate sampling circuitry according to example embodiments.

### Detailed Description of Embodiment(s)

Description of preferred embodiment(s) with reference to the drawings.

The present disclosure relates to an electrical circuitry for sampling of an analogue voltage signal. Such a sampling circuitry may, for example, be used in an ADC circuitry.

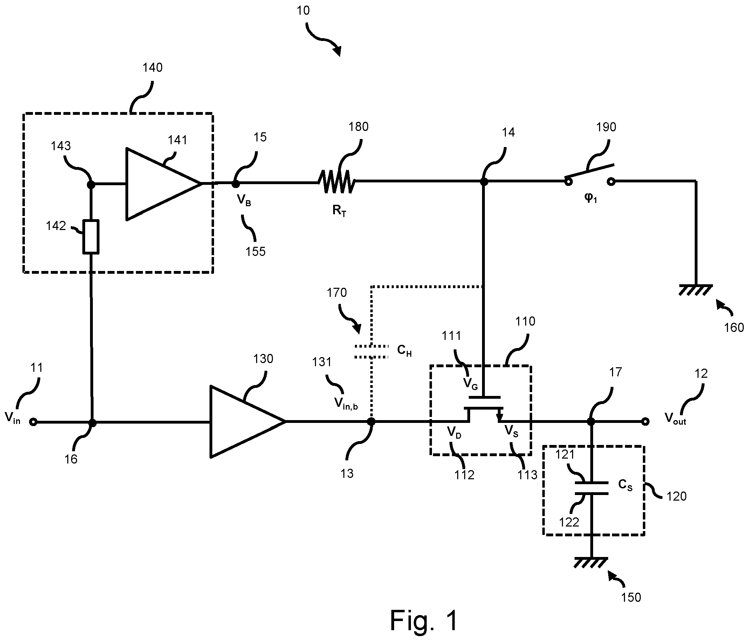

In Fig. 1, a sampling circuitry 10 is shown for sampling a voltage input signal, Vᵢₙ, 11, at an input node 16. The input signal is sampled to a voltage output signal Vₒᵤₜ, 12, at an output node 17, wherein the voltage output signal 12 is a discrete-time version of the input signal 11.

To perform the sampling, the circuitry 10 comprises a sampling transistor 110 and a sampling capacitor 120. The sampling transistor 110 connects the voltage input signal 11 to a top plate 121 of the sampling capacitor 120. The top plate 121 is the capacitor plate of the sampling capacitor 120 that is connected to the output signal 12. The other plate, i.e. a bottom plate 122 of capacitor 120, is connected to a reference voltage, in this example embodiment a ground voltage via a ground terminal 150. The sampling circuitry 10 is referred to as a 'top-plate' sampling circuitry because the sampling occurs by controlling only the electrical path to the top-plate of the capacitor 120. Contrarily, a bottom-plate sampling circuitry is a sampling circuitry comprising an additional controllable switch or transistor between the bottom plate 122 of the capacitor 120 and the reference terminal 150. Bottom-plate sampling circuitries have the disadvantage that two switches or transistors are as such connected in series, resulting in an increased impedance. As a result, bottom-plate sampling circuitries may have a more restricted bandwidth and may not be useful for high-frequency applications.

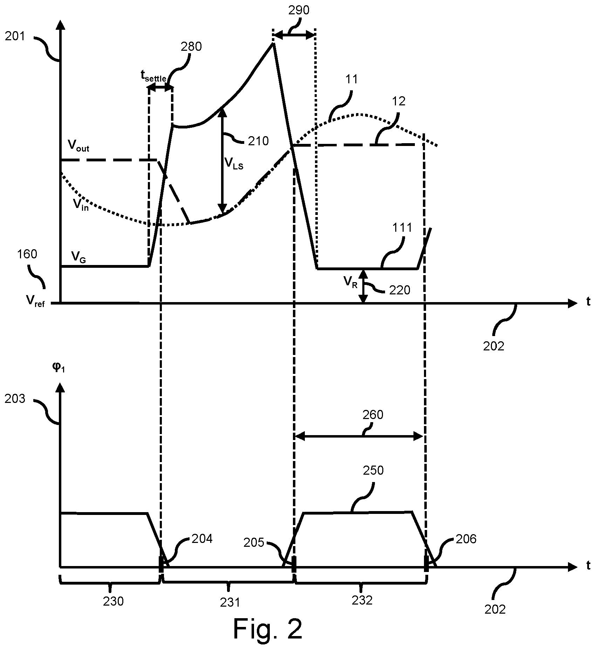

The sampling transistor 110 is operable as a switch by a gate node 14 according to a tracking phase and a holding phase. During the tracking phase, the sampling transistor 110 is configured to conduct current. Then, the sampling transistor 110 is closed and conducts the voltage input signal 11 onto the top plate 121, i.e. the input voltage 11 is propagated towards the output signal 12. During the tracking phase, the capacitor 120 is being loaded with the value of the input voltage 11 at the top plate 121. Upon switching from the tracking phase to the holding phase, the sampling transistor 110 is opened. During the holding phase, the sampling transistor 110 is configured to stop conducting current. As a result, at a time of switching from tracking to holding, an instantaneous amplitude of the input signal 11 is stored as the output signal 12 on the top plate 121 due to the capacitive loading of capacitor 120. In other words, the voltage input signal 11 is sampled on the top plate 121 as the voltage output signal 12 and maintained during the holding phase. Due to this sampling and holding behaviour, the circuitry 10 may also be referred to as a sample-and-hold circuitry 10. The tracking phase and the holding phase are further illustrated in Figure 2.

It is noted that in Fig. 1, the sampling transistor 110 is illustrated with the symbol of an NMOS transistor. It will be apparent that other types of transistors may be used, for example a PMOS transistor. It will be apparent that, if the sampling transistor were a PMOS transistor, the sampling circuitry would have complementary configurations with respect to as illustrated throughout the figures. The NMOS sampling transistor 110 has three terminals, i.e. a gate, a source and a drain, and corresponding voltages at the respective terminals, i.e. a gate voltage, Vc, 111, a source voltage, Vs, 113 and a drain voltage, V_{D}, 112. In the present disclosure, sampling transistor 110 is used as a switch and therefore, the source and drain voltages are considered equal when the switch 110 is in the 'on' state, i.e. conducting current. The transistor 110 is switched 'on' when V_{GS} is at least equal to the threshold voltage of the transistor 110.

The sampling circuitry 10 further comprises a voltage buffer 130 configured to buffer the voltage input signal 11. It is noted that the voltage buffer 130 is optional. The voltage buffer 130 has an output node 13. The sampling transistor 110 connects the voltage input signal 11 to the top plate 121 of the sampling capacitor 120 via the voltage buffer 130. The buffer 130 transforms the voltage input signal 11 to a buffered voltage signal, V_{in,b}, 131 at the output node 13. The buffer 130 provides the buffered voltage signal 131 having a lower impedance than the input signal 11. As a result, the input signal 13 can be propagated towards the output node 17 even in cases when the input signal 11 has a relatively high impedance.

The sampling circuitry 10 further comprises a bootstrapper sub-circuitry 140. The bootstrapper sub-circuitry 140 is configured to bootstrap the voltage input signal 11 with a fixed surplus voltage to a bootstrapped voltage, V_{B}, 155 at bootstrapper output node 15. The bootstrapper sub-circuitry 140 is further configured to take either the voltage input signal 11 or the buffered voltage signal 131 as input. In the example embodiment illustrated in Fig. 1, the voltage input signal 11 is taken as input. The circuitry 10 is further configured to, during the tracking phase, provide the bootstrapped voltage to the gate node 14, thereby keeping the sampling transistor 110 closed by the fixed surplus voltage. The bootstrapper sub-circuitry 140 is thus active during the tracking phase and closes transistor 110 by a constant voltage difference, i.e. the fixed surplus voltage. By providing the fixed surplus voltage, V_{GS} , i.e. a difference between 111 and 113, as well as a difference between 111 and 112 of transistor 110 remains constant when the sampling transistor 110 is closed. Thereby, signal-dependent charge injection and bandwidth influences as a result of a varying amplitude of input signal 11 are avoided.

During tracking, the voltage difference may, for example, be more than 0.2V above the threshold voltage of the sampling transistor 110. In other words, an overdrive voltage of the sampling transistor 110 may be at least 0.2V. Preferably, the overdrive voltage may be at least 0.3V. More preferable, the overdrive voltage may be at least 0.5V. The overdrive voltage may be relatively low, e.g. 0.3V or 0.4V, if the threshold voltage is relatively high, and the fixed surplus voltage is relatively limited.

Fig. 1 illustrates an example embodiment of the bootstrapper sub-circuitry 140. The bootstrapper 140 comprises a level-shifting capacitor 142 between the input voltage signal 11 and the bootstrapped voltage 155 for providing the fixed surplus voltage. The capacitor 142 is configured to hold at least part of the fixed surplus voltage across its capacitor plates. The bootstrapper 140 further comprises a buffer 141 connected in series with the capacitor 140, between the internal node 143 and the bootstrapper output node 15. The buffer 141 is configured to drive the bootstrapped voltage 155 with a relatively low impedance.

The circuitry 10 further comprises a gate switch 190 between the gate node 14 and a fixed reference voltage 160. The fixed reference voltage may, for example, be a reference voltage, Vss, provided by another circuitry. The gate switch 190 is configured to transition from open to closed during the switching from the tracking phase to the holding phase, thereby opening the sampling transistor 110.

The top-plate sampling circuitry 10 is further configured to, during the switching from the tracking phase to the holding phase, provide a resistive coupling 180 between the bootstrapped voltage 155 and the gate node 14. Thereby, a difference between the gate voltage 111 and the source voltage 113 is allowed to drop below a threshold voltage of the sampling transistor 110 so as to open the sampling transistor 110. The resistive coupling 180 is illustrated as a fixed resistor, R_{T}, yet, for operation of the circuitry 10, needs only be present during the switching from the tracking phase to the holding phase, i.e. during the closing of switch 190. The resistive coupling 180 then provides a separation between the switch 190 and the bootstrapper 140 to prevent active components of the bootstrapper 140, such as the buffer 141, from being shorted to the reference voltage 160. The resistive coupling 180 may further be provided during the tracking phase and/or during the holding phase.

The circuitry 110 further comprises a capacitance, C_{H}, between the gate node 14 and the input node 16 to hold the fixed surplus voltage during the tracking phase. In the example embodiment of Fig. 1, the capacitance is illustrated as a capacitor 170 provided between the input node 13 and the gate node 14. The capacitor 170 is drawn using dotted lines, to indicate that this capacitance does not need to be a physical capacitor 170 explicitly part of the design of the circuitry 10. The capacitance 170 may also comprise a parasitic capacitance, e.g. between the gate and drain of the sampling transistor 110.

For mere illustrative purposes, some example numerical values are provided with respect to electrical components of the circuitry 10. The capacitor Cₛ may have a capacitance of 100 femto Farad, fF, while the capacitance C_{H} may be e.g. 5 or 10 femto F, fF. R_{T} may, e.g. be a resistance of 0.5 kΩ. The terminal 150 may be at 0 Volts, V, and the fixed reference voltage 160 may, for example, also be 0V. The buffer 130 and/or buffer 141 may, for example, be powered by a rail-to-rail voltage of 1V. A rail-to-rail voltage is a difference between a voltage at a positive node and voltage at a negative node of a voltage supply. The buffer 130 may, for example, be powered between 0V and 1V nodes. The buffer 141 may, for example, operate between a node at 2V and a node at 1V. It is noted that due to the very limited nonlinearities introduced by the circuitry 10, the circuitry 10 only requires a low powering for achieving a required preset error margin for the sampling.

Fig. 2 illustrates the voltage signals 11, 12, 111 within sampling circuitry 10 during operation. The plot shown on top has an x-axis 202 indicating time and a y-axis 201 for indicating voltage amplitudes of different signals 11, 12, 111 within sampling circuitry 10. The plot shown on the bottom has the same time-axis 202 and a y-axis 203 indicating an amplitude of a clock signal φ₁. The clock signal φ₁ is a periodic voltage signal applied to the gate switch 190 of Fig. 1.

The time axis 202 shows a holding phase 230 ending at time 204. A subsequent tracking phase 231 starts at time 204 and ends at time 205. A subsequent second holding phase 232 starts at time 205 and ends at time 206. Tracking phases 231 and holding phases 230, 231 may continuously alternate each other. The clock signal, φ₁, 250, which is fed to the gate switch 190, is high during the holding phases and low during the tracking phases. Consequently, the gate switch 190 is closed during the holding phases and opened during the tracking phases. The tracking phases and the holding phases may have the same duration 260, i.e. half a clock period of the clock signal 250. During the transition from tracking phase 231 to holding phase 232 at time 205, the sampling is performed. In other words, time 205 represents the sampling time.

It is noted that in Fig. 2, the hold time 260 is indicated to start when gate signal 111 crosses the source signal 11. It will be apparent that this is a simplification under the assumption that the threshold voltage is 0V.

Fig. 2 further illustrates the input signal 11 as a function of time 202 by a dotted line. Input signal 11 is an analogue signal. During holding phase 230, of which only an end part is illustrated in Fig. 2, the gate voltage 111 is low. This results from the gate switch 190 being closed. As a result, the sampling transistor 110 is open during holding phase 230 and the output node 17 remains disconnected from the input voltage 11. Thus, voltage output signal 12 holds the value collected during the previous sampling moment on the sampling capacitor 120.

Next, at time 204, tracking is initiated upon a falling clock edge. The falling clock edge results in the opening of gate switch 190, thereby releasing the pulling of gate voltage 111 towards the fixed reference 160. This allows the gate voltage 111 to be determined by the bootstrapper 140. As a result, the voltage 111 rises until it reaches an amplitude of the bootstrapped voltage 155, which is a superposition of the input voltage 11 and the fixed surplus voltage, V_{LS}, 210. This settling of the gate voltage 111 to the bootstrapped voltage 155 following the voltage input signal takes a time duration tₛₑₜₜₗₑ 280. After settling, the voltage 111 causes the sampling transistor 110 to close, thereby connecting the output node 17 to the input voltage 11, or the buffered input voltage 131. As a result, the output voltage 12 starts tracking the input voltage 11 during the tracking phase.

Next, at time 205, i.e. during the rising clock edge of clock signal 250, the gate switch closes 190. Here, a transition happens from the tracking phase to the holding phase. The gate voltage 111 is again pulled to the fixed reference voltage 160, resulting in the opening of sampling transistor 110 and subsequent holding of the sampled value at the output node 17. It is noted that the gate voltage may not exactly reach the voltage of the reference 160, since the gate switch is not ideal and has a non-zero impedance. As a result, a voltage drop exist over the gate switch 190 and the gate node 14 remains at a voltage equal to a sum of the reference voltage 160 and a residual voltage, V_{R}, 220. This residual voltage equals the voltage drop over the gate switch 190.

It is noted that further timing effects may occur resulting from non-idealities. For example, clock edges of the clock signal 250 have a finite slope. Further, the gate switch 190 is a non-ideal switch which requires some time to open or close. In addition, the sampling transistor 110 also requires some time to switch between conducting current and being open. As a result, the switching from tracking phase to holding phase may take a small time interval, e.g. having a duration of a few picoseconds, ps. The sampling time may, for example, be indicated as the centre of such a time interval.

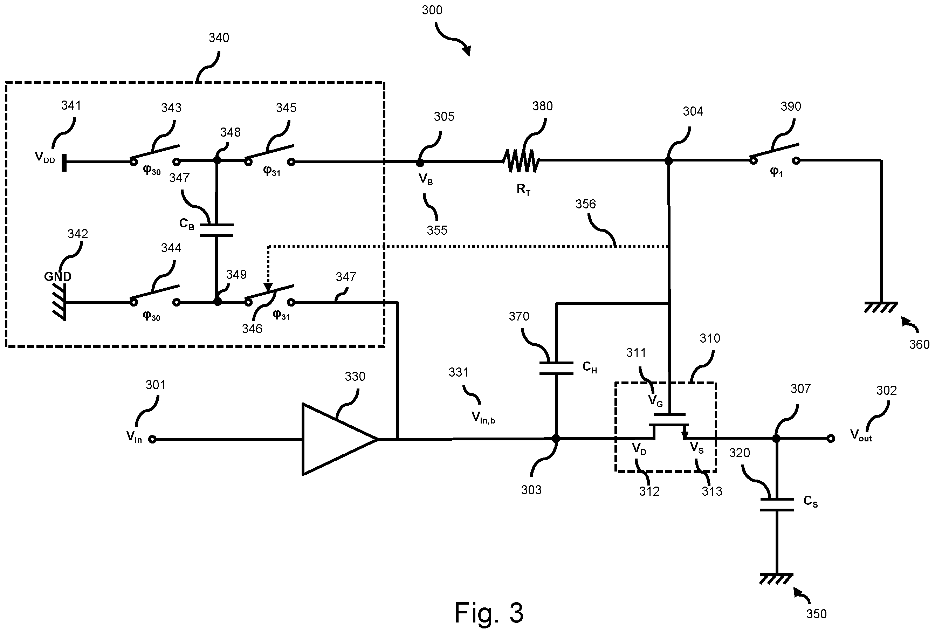

Fig. 3 shows a sampling circuitry 300 according to example embodiments. Similar to sampling circuitry 10 of Fig. 1, sampling circuitry 300 also comprises: a voltage input signal 301; a voltage output signal 302 at an output node 307; a sampling capacitor, Cs, 320 connected to a reference terminal 350; a sampling transistor 310 having a gate voltage 311, a drain voltage 312 and a source voltage 313; a gate node 304; a gate switch 390 connected to a fixed reference voltage 360; a voltage buffer 330 providing a buffered voltage input signal, V_{in,b}, 331 at a node 303; a resistive coupling 380 in the form of a resistor R_{T},; and a bootstrapper 340 providing a bootstrapped voltage, V_{B}, 355 at bootstrapper node 305. Further, similar to capacitance 170 of Fig. 1, sampling circuitry 300 comprises a physical capacitor 370 for providing the holding capacitance, C_{H}.

Furthermore, the bootstrapper 340 of sampling circuitry 300 comprises a level-shifting capacitor, C_{B}, 347 between the input voltage signal 301 and the bootstrapped voltage 355 for providing the fixed surplus voltage. In particular, the level-shifting capacitor 347 is provided between the buffered input voltage signal 331 and the bootstrapped voltage 355. The capacitor 347 is alternately used by the bootstrapper 340 for providing voltage 355, during the tracking phase, and recharged, during the holding phase. The recharging may, for example, be performed by connecting the capacitor 347 to a power supply having nodes, V_{DD}, 341 and GND, 342 during the holding phase. This may, for example, be done by, during the holding phase, turning on switches 343, 344 for connecting the capacitor 347 to the supply nodes 341, 342. As such, capacitor 347 can act as a battery during a subsequent tracking phase. Analogously, switches 345, 346 may be used to connect the capacitor 347 to the sampling circuitry 110 during the tracking phase. As such, switches 343, 344 are be controlled by a switch control signal, φ₃₀, which may coincide with a clock signal φ₁ that controls the gate switch 390. Switches 345, 346 may be controlled by an inverse, φ₃₁, of the switch control signal. Optionally, switches 345, 346 may be controlled by the gate node 304, see the dotted line 356 providing such a connection.

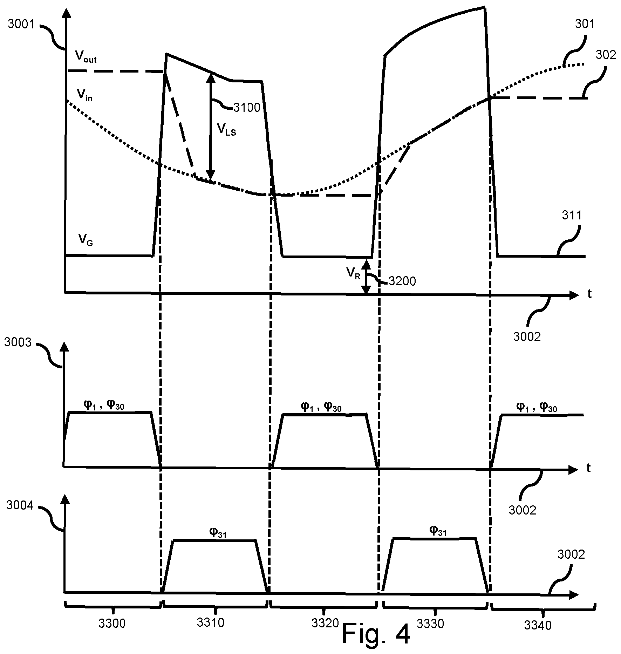

Fig. 4 illustrates the voltage signals 301, 302, 311 within sampling circuitry 300 during operation. Similar to Fig. 2, Fig. 4 illustrates: a time x-axis 3002; a voltage amplitude y-axis 3001; tracking phases 3310, 3330; holding phases 3300, 3320, 3340; the input voltage 301; the output voltage 302; the gate voltage 311; a fixed surplus voltage 3100; and a residual voltage 3200. Fig. 4 further shows switch control signal φ₃₀, which may coincide with clock signal φ₁ as mentioned above, by y-axis 3003 and switch control signal φ₃₁.

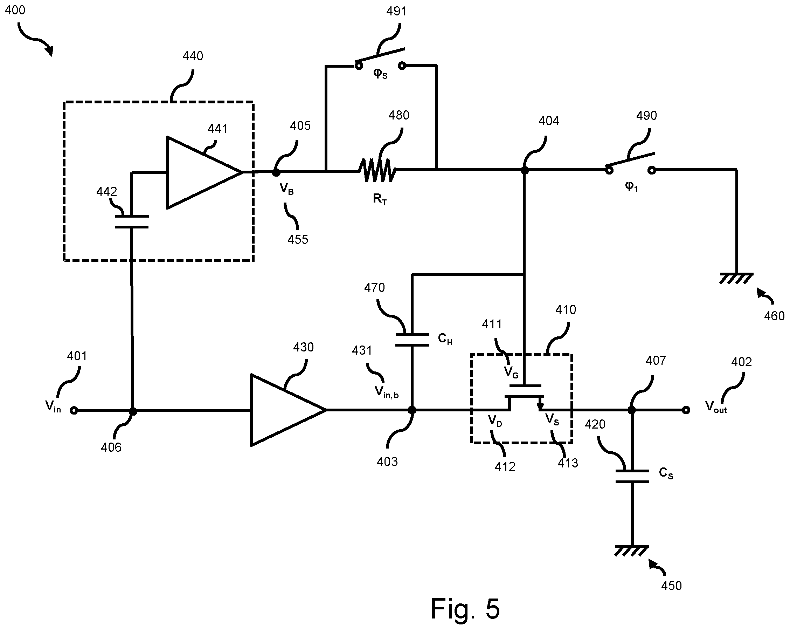

Fig. 5 shows a sampling circuitry 400 according to example embodiments. Similar to sampling circuitry 10 of Fig. 1, sampling circuitry 400 also comprises: a voltage input signal 401; a voltage output signal 402 at an output node 407; a sampling capacitor, Cs, 420 connected to a reference terminal 450; a sampling transistor 410 having a gate voltage 411, a drain voltage 412 and a source voltage 413; a gate node 404; a gate switch 490 connected to a fixed reference voltage 460 and controlled by clock signal φ₁; a voltage buffer 430 providing a buffered voltage input signal, V_{in,b}, 431 at a node 403; a resistive coupling 480 in the form of a resistor R_{T}; and a bootstrapper 440, comprising a bootstrapper buffer 441 and a level-shifting capacitor 442, and providing a bootstrapped voltage, V_{B}, 455 at bootstrapper node 405. Further, similar to capacitance 170 of Fig. 1, sampling circuitry 400 comprises a physical capacitor 470 for providing the holding capacitance, C_{H}.

Fig. 5 further shows a start-up switch 491 for shortcutting the bootstrapped voltage to the gate node during an initial portion 580 of the tracking phase. This is done so as to accelerate settling of the gate voltage 411 to the bootstrapped voltage 455 following the voltage input signal. By the start-up switch 491, the resistive coupling is shortcut during the initial portion of the tracking phase. The start-up switch 491 is configured to be closed during the initial portion 580 and open at least during the switching from the tracking phase to the holding phase. The start-up switch 491 is provided in parallel with the resistive coupling 480 and controlled by a switch controlling signal φₛ.

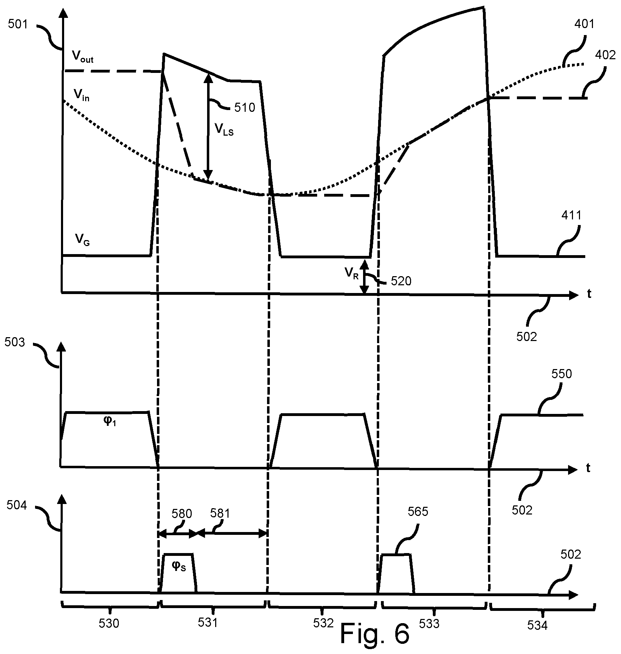

Fig. 6 illustrates the use of start-up switch 491 of Fig. 5. Fig. 6 illustrates the voltage signals 401, 402, 411 within sampling circuitry 400 during operation. Similar to Fig. 2, Fig. 4 illustrates: a time x-axis 502; a voltage amplitude y-axis 501; tracking phases 531, 533; holding phases 530, 532, 534; the input voltage 401; the output voltage 402; the gate voltage 411; a fixed surplus voltage, V_{LS}, 510; a residual voltage 520; and clock signal, φ₁ , 550 for controlling the gate switch 490, indicated by y-axis 503. Fig. 6 further shows, indicated by y-axis 504, switch control signal, φₛ, 565 for controlling the start-up switch 491. The control signal 565 is configured to periodically switch on during an initial portion 580 of the tracking phase. This allows the quicker settling of the gate voltage 411. The control signal 565 is turned off during the holding phase 530, 532, 534 in order to prevent the bootstrapper 440 from being pulled towards the reference 460, which would be a waste of energy and may even lead to a short circuit. According to example embodiments, the control signal 565 is configured to be turned off during a remainder portion 581 of the tracking phase. This may also result in power saving. Further, the start-up switch 491 may be non-ideal and therefore have a non-zero resistance. Therefore, the start-up switch 491 provides a non-linear resistance, while resistive coupling 480 provides a linear resistance. As a result, the gate voltage 411 may more linearly follow the voltage input 431.

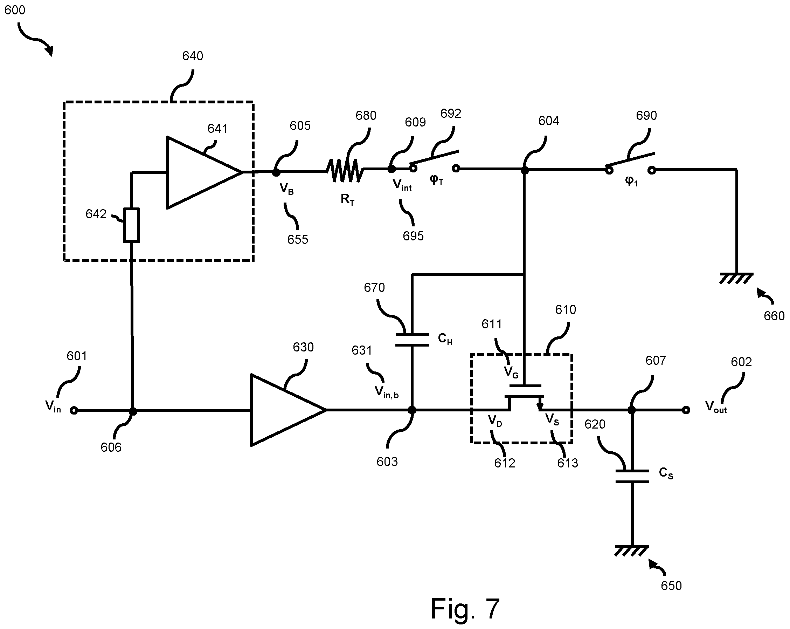

Fig. 7 shows a sampling circuitry 600 according to example embodiments. Similar to sampling circuitry 10 of Fig. 1, sampling circuitry 600 also comprises: a voltage input signal 601 at input node 606; a voltage output signal 602 at an output node 607; a sampling capacitor, Cs, 620 connected to a reference terminal 650; a sampling transistor 610 having a gate voltage 611, a drain voltage 612 and a source voltage 613; a gate node 604; a gate switch 690 connected to a fixed reference voltage 660 and controlled by clock signal φ₁; a voltage buffer 630 providing a buffered voltage input signal 631 at a node 603; a resistive coupling 680 in the form of a resistor R_{T}; and a bootstrapper 640, comprising a bootstrapper buffer 641 and a level-shifting capacitor 642, and providing a bootstrapped voltage 655 at bootstrapper node 605. Further, similar to capacitance 170 of Fig. 1, sampling circuitry 600 comprises a physical capacitor 670 for providing the holding capacitance, C_{H}.

The sampling circuitry 600 of is further configured to: during an end portion 890 of the holding phase, interrupt the bootstrapping of the gate node 604 so as to limit current otherwise flowing from the bootstrapper sub-circuitry 640 through the resistive coupling 680 to the fixed reference voltage 660. To this end, the sampling circuitry 600 further comprises a power-saving switch 692 for interrupting the bootstrapping by disconnecting a node 605 of the supplied bootstrapped voltage 655 from the gate node 604. The power-saving switch 692 is configured to be open during the end portion 890 of the tracking phase and closed at least during the switching from the tracking phase to the holding phase. This can be achieved by controlling the power-saving switch 692 by a corresponding switch control signal φ_{T}. The power-saving switch 692 is provided in series with the resistive coupling 680, resulting in an intermediate voltage 695 at an intersection node 609 between the power-saving switch 692 and the resistive coupling 680.

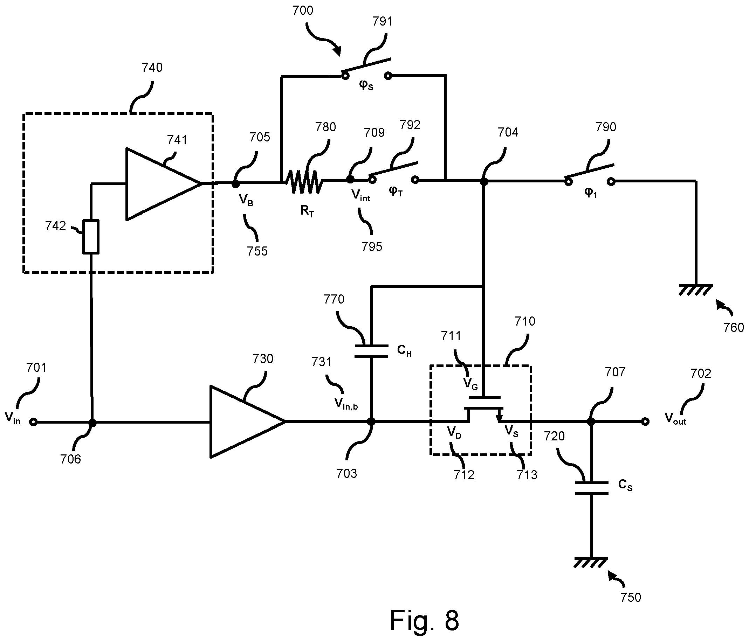

Fig. 8 shows a sampling circuitry 700 according to example embodiments. Similar to sampling circuitry 600 of Fig. 7, sampling circuitry 700 also comprises: a voltage input signal 701 at input node 706; a voltage output signal 702 at an output node 707; a sampling capacitor, Cs, 720 connected to a reference terminal 750; a sampling transistor 710 having a gate voltage 711, a drain voltage 712 and a source voltage 713; a gate node 704; a gate switch 790 connected to a fixed reference voltage 760 and controlled by clock signal φ₁; a voltage buffer 730 providing a buffered voltage input signal 731 at a node 703; a resistive coupling 780 in the form of a resistor R_{T}; a bootstrapper 740, comprising a bootstrapper buffer 741 and a level-shifting capacitor 742, and providing a bootstrapped voltage 755 at bootstrapper node 705; and a power-saving switch 792, controlled by a switch control signal φ_{T}, and provided in series with the resistive coupling 780, resulting in an intermediate voltage 795 at an intersection node 709 between the power-saving switch 792 and the resistive coupling 780. Further, similar to capacitance 170 of Fig. 1, sampling circuitry 700 comprises a physical capacitor 770 for providing the holding capacitance, C_{H}.

Furthermore, Fig. 8 shows a start-up switch 791, similar to start-up switch 491 in Fig. 5, configured in parallel over a series configuration of the resistive coupling and the power-saving switch.

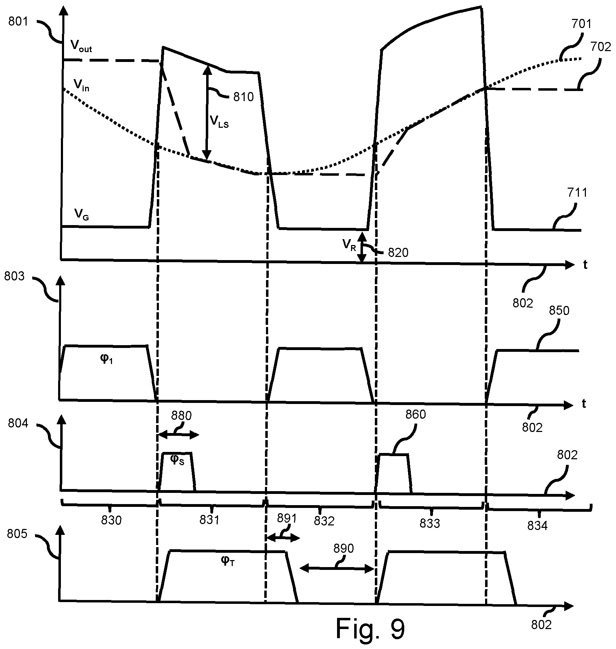

Fig. 9 illustrates the combined use of start-up switch 791 and power-saving switch 792 of Fig. 8. Similar to Fig. 2, Fig. 9 illustrates: a time x-axis 802; a voltage amplitude y-axis 801; tracking phases 831, 833; holding phases 830, 832, 834; the input voltage 701; the output voltage 702; the gate voltage 711; a fixed surplus voltage, V_{LS}, 810; a residual voltage 820; and clock signal, φ₁ , 850 for controlling the gate switch 790, indicated by y-axis 803. Fig. 9 further shows, indicated by y-axis 804, switch control signal, φₛ, 860 for controlling the start-up switch 791. Similar to control signal 565 of Fig. 6, the control signal 860 is configured to periodically switch on during an initial portion 880 of the tracking phase 831, 833 to allow speeding up of the settling of the gate voltage 711.

Fig. 9 further illustrates switch control signal φ_{T} by y-axis 805. Such a control signal may be used for controlling power-saving switch 792. A similar control signal may, for example, be used for controlling power-saving switch 692 of sampling circuitry 600 of Fig. 7. The control signal φ_{T} is off during an end portion 890 of the tracking phase. During the remainder 891 of the holding phase, the control signal φ_{T} may be on or off, as long as it is on during the switching from the tracking phase to the holding phase. During the end portion 890, and in fact whenever else the switch 692, 792 is opened, power is being saved by opening the switch 692, 792. The power-saving switch is configured to remain on during the tracking phase, to allow the bootstrapper to provide the fixed surplus voltage.

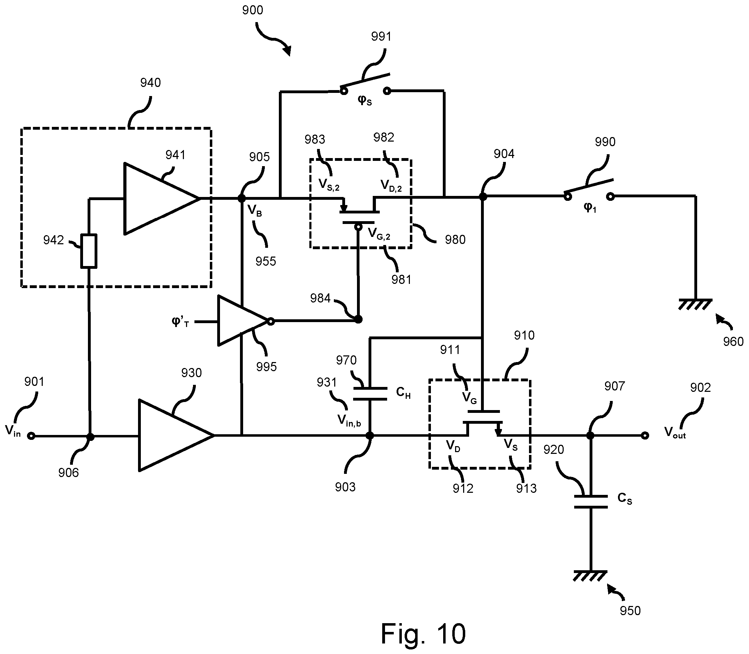

Fig. 10 shows a sampling circuitry 900 according to example embodiments. Similar to sampling circuitry 700 of Fig. 8, sampling circuitry 900 also comprises: a voltage input signal 901 at input node 906; a voltage output signal 902 at an output node 907; a sampling capacitor, Cs, 920 connected to a reference terminal 950; a sampling transistor 910 having a gate voltage 911, a drain voltage 912 and a source voltage 913; a gate node 904; a gate switch 990 connected to a fixed reference voltage 960 and controlled by clock signal φ₁; a voltage buffer 930 providing a buffered voltage input signal 931 at a node 903; a resistive coupling 980; a bootstrapper 940, comprising a bootstrapper buffer 941 and a level-shifting capacitor 942, and providing a bootstrapped voltage 955 at bootstrapper node 905; and a start-up switch 991. Further, similar to capacitance 170 of Fig. 1, sampling circuitry 900 comprises a physical capacitor 970 for providing the holding capacitance, C_{H}.

Sampling circuitry 900 further comprises a second transistor 980 configured as a power-saving switch. The second transistor 980 is further configured to provide the resistive coupling 980 between the bootstrapped voltage 955 and the gate node 904 when closed. The second transistor 980 is configured to perform a dual functionality of both providing a controllable resistive coupling, as well as implementing the interrupting for power-saving purposes. The second transistor has a gate voltage 981, a drain voltage 982 and a source voltage 983. The second transistor is illustrated here as a PMOS transistor. It will be apparent that other transistor configurations may provide the same functionalities.

Sampling circuitry 900 further comprises an inverter 995 configured to provide the second gate voltage 981 for controlling a second gate node 984 of the second transistor 980. The inverter 995 may be powered by a voltage difference between the voltage input signal 901, 931 and the bootstrapped voltage 955. The inverter 995 may further be configured to provide the second gate voltage 981 such that the second transistor 980 is open during an end portion, e.g. end portion 890, of the tracking phase and closed at least during the switching from the tracking phase to the holding phase. An inverted signal of the switch control signal φ_{T} illustrated in Fig. 9 may be provided as input to the inverter 995.

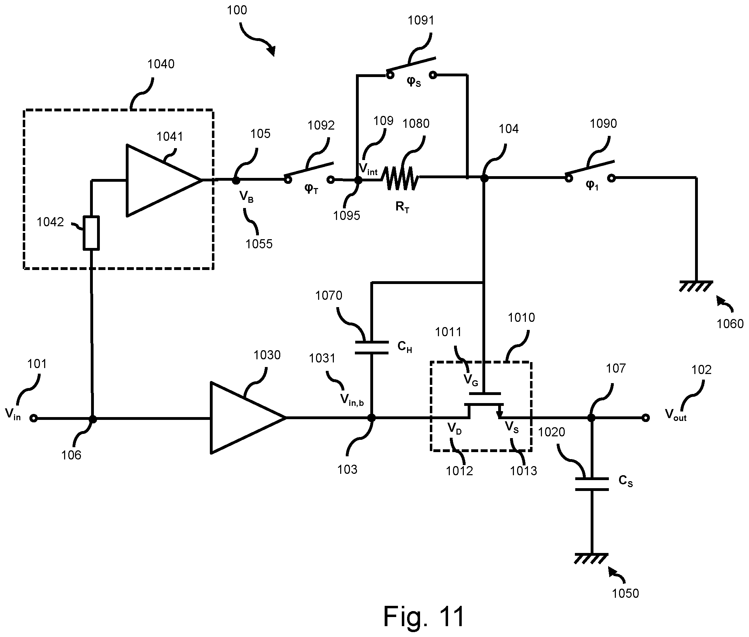

Fig. 11 shows a sampling circuitry 100 according to example embodiments. Similar to sampling circuitry 700 of Fig. 8, sampling circuitry 100 also comprises: a voltage input signal 101 at input node 106; a voltage output signal 102 at an output node 107; a sampling capacitor, Cs, 1020 connected to a reference terminal 1050; a sampling transistor 1010 having a gate voltage 1011, a drain voltage 1012 and a source voltage 1013; a gate node 104; a gate switch 1090 connected to a fixed reference voltage 1060 and controlled by clock signal φ₁; a voltage buffer 1030 providing a buffered voltage input signal 1031 at a node 103; a resistive coupling 1080 in the form of a resistor R_{T}; a bootstrapper 1040, comprising a bootstrapper buffer 1041 and a level-shifting capacitor 1042, and providing a bootstrapped voltage 1055 at bootstrapper node 105; a power-saving switch 1092, controlled by a switch control signal φ_{T}, and provided in series with the resistive coupling 1080, resulting in an intermediate voltage 1095 at an intersection node 109 between the power-saving switch 1092 and the resistive coupling 1080; and a start-up switch 1091. Different than in the embodiment shown in Fig. 8, the start-up switch 1091 is configured in parallel over the resistive coupling and in series with the power-saving switch 1092. Further, similar to capacitance 170 of Fig. 1, sampling circuitry 100 comprises a physical capacitor 1070 for providing the holding capacitance, C_{H}.

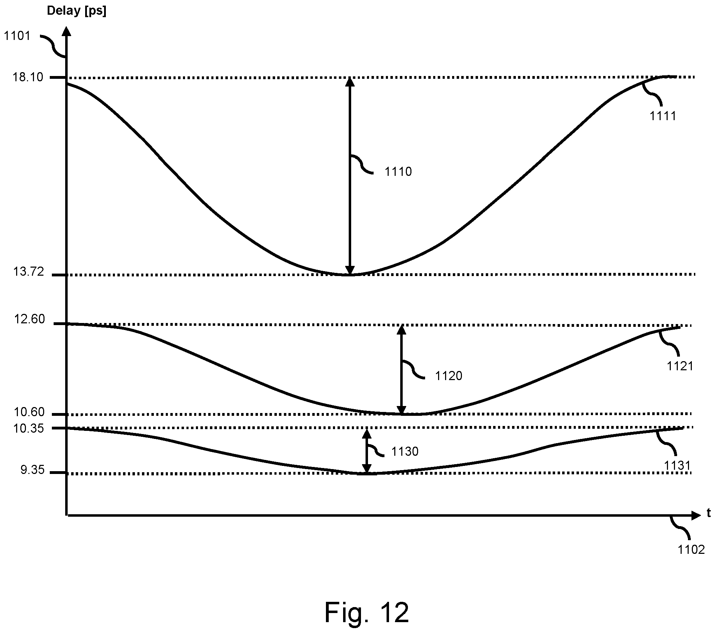

Fig. 12 illustrates results of the limited non-linear behaviour of sampling circuitries according to example embodiments. In Fig. 12, the x-axis 1102 illustrates the progression of time. The y-axis 1101 illustrates signal-dependent delays with respect to the ideal sampling moment introduced by a sampling circuitry. A signal-dependent delay indicated along axis 1101 thus represents an offset provided to the ideal sampling moment due to the non-linear behaviour of the sampling circuitry. This delay is expressed in picoseconds, ps. Results are shown over a period of one clock signal on the x-axis 1102.

Curve 1111 shows results for a sampling circuitry according to the prior art that applies bootstrapping using a bootstrapper similar to the bootstrapper 340 of Fig. 3 with switches 343, 344, 345, 346 yet without resistive coupling 380. Fig. 12 shows that the delay for such a sampling circuitry, the introduced unwanted delay varies between about 13.72 ps and 18.10 ps. This corresponds to a variation of about 4.38 ps.

Curve 1121 shows results for a sampling circuitry according to the prior art that applies bootstrapping using a bootstrapper similar to the bootstrapper 140 of Fig. 1 with a bootstrapper buffer 141 to provide active driving. Fig. 12 shows that the delay for such a sampling circuitry, the introduced unwanted delay varies between about 12.60 ps and 10.60 ps. This corresponds to a variation of about 2 ps.

Curve 1131 shows results for a sampling circuitry according example embodiments. Fig. 12 shows that the delay for such a sampling circuitry, the introduced unwanted delay varies between about 10.35 ps and 9.35 ps. This corresponds to a variation of about 1 ps. It will be apparent that this concerns a significant improvement both in absolute value of the introduced delays, as well as concerning the variation of the introduced delays.

As used in this application, the term "circuitry" may refer to one or more or all of the following: (a) hardware-only circuit implementations (such as implementations in only analog and/or digital circuitry) and (b) combinations of hardware circuits and software, such as (as applicable): (i) a combination of analog and/or digital hardware circuit(s) with software/firmware and (ii) any portions of hardware processor(s) with software (including digital signal processor(s)), software, and one or more memories that work together to cause an apparatus, such as a mobile phone or server, to perform various functions) and (c) hardware circuit(s) and or processor(s), such as a microprocessor(s) or a portion of a microprocessor(s), that requires software (e.g., firmware) for operation, but the software may not be present when it is not needed for operation. This definition of circuitry applies to all uses of this term in this application, including in any claims. As a further example, as used in this application, the term circuitry also covers an implementation of merely a hardware circuit or processor (or multiple processors) or portion of a hardware circuit or processor and its (or their) accompanying software and/or firmware. The term circuitry also covers, for example and if applicable to the particular claim element, a baseband integrated circuit or processor integrated circuit for a mobile device or a similar integrated circuit in server, a cellular network device, or other computing or network device.

Although the present invention has been illustrated by reference to specific embodiments, it will be apparent to those skilled in the art that the invention is not limited to the details of the foregoing illustrative embodiments, and that the present invention may be embodied with various changes and modifications without departing from the scope thereof. The present embodiments are therefore to be considered in all respects as illustrative and not restrictive, the scope of the invention being indicated by the appended claims rather than by the foregoing description, and all changes which come within the meaning and range of equivalency of the claims are therefore intended to be embraced therein. In other words, it is contemplated to cover any and all modifications, variations or equivalents that fall within the scope of the basic underlying principles and whose essential attributes are claimed in this patent application. It will furthermore be understood by the reader of this patent application that the words "comprising" or "comprise" do not exclude other elements or steps, that the words "a" or "an" do not exclude a plurality, and that a single element, such as a computer system, a processor, or another integrated unit may fulfil the functions of several means recited in the claims. Any reference signs in the claims shall not be construed as limiting the respective claims concerned. The terms "first", "second", third", "a", "b", "c", and the like, when used in the description or in the claims are introduced to distinguish between similar elements or steps and are not necessarily describing a sequential or chronological order. Similarly, the terms "top", "bottom", "over", "under", and the like are introduced for descriptive purposes and not necessarily to denote relative positions. It is to be understood that the terms so used are interchangeable under appropriate circumstances and embodiments of the invention are capable of operating according to the present invention in other sequences, or in orientations different from the one(s) described or illustrated above.

## Claims

1. A top-plate sampling circuitry (10) for sampling a voltage input signal (11), the circuitry comprising:
- a sampling transistor (110) and a sampling capacitor (120), wherein the sampling transistor connects the voltage input signal to a top plate (121) of the sampling capacitor; wherein the sampling transistor is operable as a switch by a gate node (14) according to a tracking phase (231) and a holding phase (230, 232); wherein, during the tracking phase, the sampling transistor is closed and conducts the voltage input signal onto the top plate; and wherein, upon switching (290) from the tracking phase to the holding phase, the sampling transistor is opened such that the voltage input signal is sampled on the top plate as a voltage output signal (12), and maintained during the holding phase;
- a bootstrapper sub-circuitry (140) configured to bootstrap the voltage input signal with a fixed surplus voltage (210) to a bootstrapped voltage (155), and to, during the tracking phase, provide the bootstrapped voltage to the gate node, thereby keeping the sampling transistor closed by the fixed surplus voltage; and
- a gate switch (190) between the gate node and a fixed reference voltage (160), wherein the gate switch is configured to transition from open to closed during the switching, thereby opening the sampling transistor at a sampling time;
wherein the circuitry is further configured to, during the switching from the tracking phase to the holding phase, provide a resistive coupling (180) between the bootstrapped voltage and the gate node, thereby allowing a difference between a gate voltage (111) at the gate node and a source voltage at a source node to drop below a threshold voltage of the sampling transistor so as to open the sampling transistor.

2. The circuitry according to claim 1, further configured to further provide the resistive coupling during the tracking phase.

3. The circuitry according to claim 1 or 2, further configured to further provide the resistive coupling during the holding phase.

4. The circuitry according to any one of claims 1-3, further configured to, during an initial portion (580) of the tracking phase, shortcut (491) the bootstrapped voltage to the gate node so as to accelerate settling of the gate voltage to the bootstrapped voltage following the voltage input signal.

5. The circuitry according to claim 4, further comprising a start-up switch (491) for performing the shortcutting by shortcutting the resistive coupling, the start-up switch configured to be closed during the initial portion (580) and open at least during the switching from the tracking phase to the holding phase.

6. The circuitry according to claim 5, wherein the start-up switch is provided in parallel with the resistive coupling.

7. The circuitry according to any one of the preceding claims, further configured to, during an end portion (890) of the holding phase, interrupt the bootstrapping so as to limit current otherwise flowing from the bootstrapper sub-circuitry through the resistive coupling to the fixed reference voltage.

8. The circuitry according to claim 7, further comprising a power-saving switch (692) for the interrupting of the bootstrapping by disconnecting the supplied bootstrapped voltage from the gate node, wherein the power-saving switch is configured to be open during the end portion (890) of the tracking phase and closed at least during the switching from the tracking phase to the holding phase.

9. The circuitry according to claim 8, further comprising a second transistor (980) configured as the power-saving switch, wherein the second transistor is further configured to provide the resistive coupling between the bootstrapped voltage and the gate node when closed.

10. The circuitry according to claim 8, wherein the power-saving switch is provided in series with the resistive coupling.

11. The circuitry according to claim 5 in combination with any of claims 8, 9 and 10, wherein the start-up switch is configured in parallel over the resistive coupling and the power-saving switch.

12. The circuitry according to any one of claims 1-8, 10 or 11, further comprising a resistor (180) between the bootstrapped voltage and the gate node to provide the resistive coupling as a constant resistive coupling.

13. The circuitry according to any one of the preceding claims, further comprising a voltage buffer configured to buffer the voltage input signal, wherein the sampling transistor connects the voltage input signal to the top plate of the sampling capacitor via the voltage buffer, and wherein the bootstrapper sub-circuitry is configured to take the voltage input signal of the voltage buffer as input.

14. The circuitry according to any of the preceding claims, wherein the bootstrapper sub-circuitry comprises a level-shifting capacitor (142, 347) between the input voltage signal and the bootstrapped voltage for providing the fixed surplus voltage.

15. The circuitry according to any one of the preceding claims, further comprising a capacitance (170) between the gate node and an input node of the sampling transistor to hold the fixed surplus voltage during the tracking phase.
